**Europäisches Patentamt**

**European Patent Office**

**Office européen des brevets**

(19)

(11) Numéro de publication: **0 179 719**
**B1**

(12)

# FASCICULE DE BREVET EUROPÉEN

(45) Date de publication du fascicule du brevet:
**20.07.88**

(21) Numéro de dépôt: **85402046.8**

(22) Date de dépôt: **22.10.85**

(51) Int. Cl.⁴: **H 01 L 21/84, H 01 L 21/86,**
**H 01 L 21/203, H 01 L 21/205**

(54) **Procédé de fabrication de circuits intégrés sur substrat isolant.**

(30) Priorité: **23.10.84 FR 8416202**

(43) Date de publication de la demande:
**30.04.86 Bulletin 86/18**

(45) Mention de la délivrance du brevet:
**20.07.88 Bulletin 88/29**

(84) Etats contractants désignés:
**DE FR GB IT NL**

(56) Documents cité:
**EP-A-0 068 094**
**EP-A-0 077 020**
**DE-A-1 806 578**
**DE-B-2 535 813**

(73) Titulaire: **SGS- THOMSON MICROELECTRONICS**
**S.A., 101, bld Murat, F-75016 Paris (FR)**

(72) Inventeur: **Borel, Joseph, THOMSON- CSF SCPI**
**173, bld Haussmann, F-75379 Paris Cedex 08 (FR)**

(74) Mandataire: **Guérin, Michel, THOMSON- CSF SCPI**
**19, avenue de Messine, F-75008 Paris (FR)**

EP 0 179 719 B1

LIBER, STOCKHOLM 1988

## Description

La présente invention concerne la fabrication des circuits intégrés.

On réalise actuellement le plus souvent les circuits intégrés sur un substrat de silicium monocristallin.

Mais dans certaines applications, on préfère les réaliser sur un substrat isolant, notamment pour des circuits devant fonctionner dans un environnement de radiations; entre autres ces radiations auraient pour effet d'engendrer des courants parasites dans le corps d'un substrat de silicium. Cet effet est fortement réduit si on réalise les éléments de circuit sur de petits îlots de matériau semi-conducteur monocristallin déposés sur un substrat isolant.

Pour réaliser ces circuits intégrés sur substrat isolant, on fait habituellement croître par épitaxie une couche de matériau semi-conducteur monocristallin (on parlera dans la suite de silicium monocristallin qui est le matériau le plus courant aujourd'hui) sur le substrat isolant, après quoi on grave cette couche selon un motif d'îlots individuels.

Un problème délicat apparaît lors de la croissance épitaxiale cette étape se fait à très haute température et, lorsque l'épaisseur de silicium monocristallin désirée est obtenue, on doit laisser refroidir le substrat isolant recouvert de silicium. Le substrat et le silicium ayant tous deux des structures cristallines mais n'ayant pas les mêmes coefficients de dilatation thermique, il apparaît à l'interface des tensions très fortes créant des dislocations importantes du silicium sur une épaisseur non négligeable (100 à 400 nm) (1000 à 4000 angströms). La zone disloquée a de très mauvaises propriétés électriques et laisse passer des courants de fuite entre les éléments de circuit qui devraient être parfaitement isolés, ces courants de fuite pouvant d'ailleurs augmenter considérablement en présence de radiations.

On a pu imaginer des structures dans lesquelles, au lieu d'utiliser un substrat isolant habituel en corindon (variété de saphir), on utiliserait en substrat de zircone (oxyde de zirconium). Dans ce cas le risque de dislocation lors du refroidissement existe toujours mais on peut le réduire en diffusant de l'oxygène à travers la zircone (par la face arrière non recouverte de silicium épitaxié, en protégeant la face avant recouverte de silicium); cette diffusion est faite après la croissance épitaxiale mais pendant que le substrat est encore à la haute température de la phase d'épitaxie. L'oxygène diffuse bien à travers la zircone et crée à l'interface une couche de silicium oxydé qui constitue un joint de dilatation efficace entre le silicium et l'isolant lors du refroidissement ultérieur; les dislocations sont ainsi fortement réduites. L'inconvénient principal est évidemment la nécessité d'utiliser un substrat de zircone qui est un matériau beaucoup moins courant et moins facile à travailler que le corindon.

La présente invention propose un nouveau procédé de fabrication de circuits intégrés sur substrat isolant. Ce procédé est du type général indiqué ci-dessus, c'est-à-dire qu'il consiste à former sur un substrat isolant monocristallin une couche semi-conductrice monocristalline, le substrat et la couche semi-conductrice ayant des structures cristallines très voisines. Selon l'invention, on dépose sur le substrat isolant une fine couche d'oxyde de silicium, on grave cette couche selon un motif de petits îlots individuels, on forme une couche semi-conductrice monocristalline à partir des germes monocristallins constitués par les zones de substrat isolant entre les îlots, et on grave cette couche selon un motif correspondant essentiellement au motif de gravure de l'oxyde de silicium. De préférence, l'étape de formation de la couche semi-conductrice monocristalline se fait en deux phases: on dépose d'abord une couche semi-conductrice polycristalline, puis, à haute température, on effectue une recristallisation dans toute cette couche à partir des germes monocristallins constitués par le substrat isolant non recouvert d'oxyde; cette recristallisation s'étend non seulement verticalement au-dessus des germes mais aussi latéralement au-dessus des îlots situés entre ces germes.

L'invention est tout particulièrement applicable à la formation de couches de silicium monocristallin, et un substrat de corindon s'avère approprié.

Avec ce procédé, pendant le refroidissement du substrat recouvert de silicium monocristallin, il se produit bien des contraintes importantes au niveau de l'interface entre le silicium et le substrat là où le silicium est directement en contact avec le substrat, mais les dislocations qui se produisent n'ont pas d'incidence sur le fonctionnement du circuit car le silicium monocristallin sera enlevé à ces endroits lors de la gravure prévue après la phase de croissance épitaxiale ou de recristallisation à haute température. Au contraire, à l'endroit des îlots individuels d'oxyde de silicium, l'oxyde est visqueux à haute température et assure un amortissement des contraintes évitant les dislocations dans les parties actives de silicium monocristallin (les parties qui subsisteront après gravure).

C'est pourquoi, on prévoit de préférence que le motif de gravure du silicium monocristallin est un motif déduit de celui de l'oxyde de silicium mais légèrement rétreint pour être sûr que l'oxyde exerce son action sur la totalité des zones actives de silicium monocristallin.

D'autres caractéristiques et avantages de l'invention apparaîtront à la lecture de la description détaillée qui suit et qui est faite en référence aux dessins annexés dans lesquels

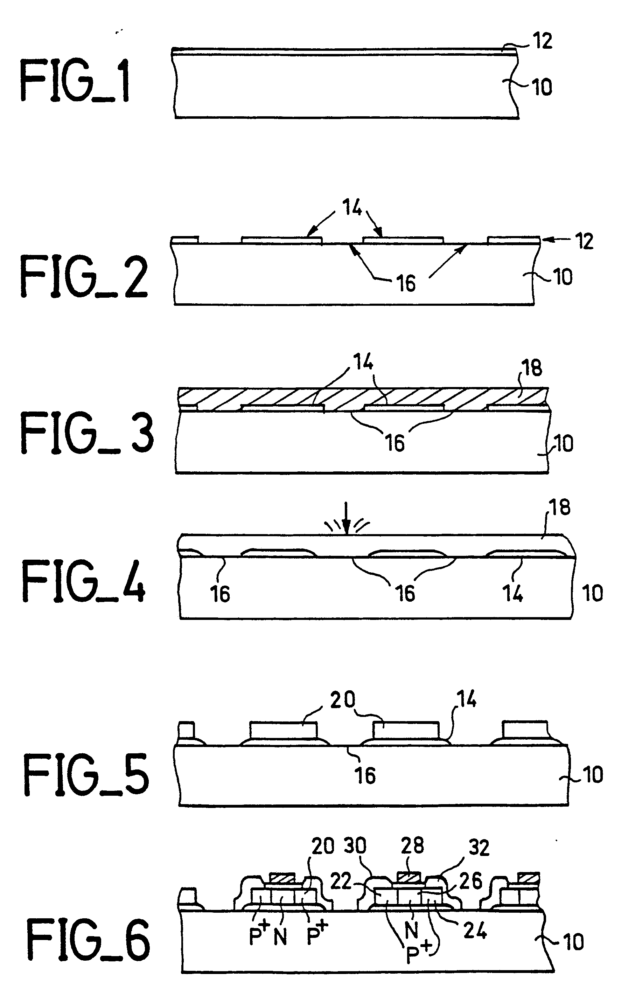

- les figures 1 à 6 représentent des étapes successives de fabrication d'un circuit intégré selon le procédé de la présente invention.

Conformément à l'habitude dans ce domaine, les échelles ne sont pas respectées, pour faciliter la lisibilité des schémas.

Seules les étapes initiales de fabrication, correspondant à l'invention proprement dite, seront détaillées; les étapes ultérieures peuvent être classiques.

On part d'un substrat isolant 10 qui est de préférence un substrat monocristallin de corindon (variété d'alumine cristalline). Sa structure cristalline est assez proche de celle du silicium.

On dépose, par décomposition chimique en phase gazeuse, un fine couche 12 d'oxyde de silicium ($SiO_2$). L'espaisseur peut être de plusieurs dizaines de nanomètres (plusieurs centaines d'angströms) (figure 1).

On grave cette couche 12 par un procédé photolithographique (dépôt d'une résine photosensible, exposition aux ultraviolets en présence d'un masque de définition du motif de gravure, développement de la résine, et gravure chimique ou par plasma de l'oxyde non protégé par le motif de résine subsistant). Le motif de gravure laisse subsister de petits îlots individuels d'oxyde 14 qui se situent aux emplacements où devront exister des zones actives de silicium monocristallin. Entre les îlots apparaissent des zones dénudées 16 où le substrat isolant monocristallin affleure (figure 2).

On dépose alors une couche uniforme 18 de silicium polycris tallin par décomposition chimique en phase gazeuse à basse pression (décomposition de Silane). Ce dépôt recouvre uniformément la surface du substrat, au-dessus des îlots 14 et des zones 16. L'épais seur peut être de un micron environ (figure 3).

On procède à une recristallisation à haute température de cette couche de silicium 18. Une telle recristallisaion est possible en général lorsque des germes de silicium monocristallin sont en contact avec le silicium polycristallin. Ici, il n'y a pas de germes de silicium monocristallin, mais les zones dénudées 16 sont des zones monocristallines de corindon et, comme le corindon a une structure cristalline dont la maille est très proche de celle du silicium, ces zones jouent le rôle de germes, et elles sont suffisamment nombreuses pour que toute la couche 18 se réordonne en s'alignant sur l'orientation du corindon. La couche 18 devient monocristalline dans sa totalité, les îlots 14 étant suffisamment petits (quelques microns de large) pour qu'une recristallisation efficace soit induite au-dessus de la totalité d'un îlot par les deux germes qui l'encadrent.

Pendant cette recristallisation à haute température, l'oxyde de silicium des îlots a tendance à fondre et à acquérir une certaine viscosité (figure 4).

La recristallisation peut être effectuée notamment en irradiant localement la surface de la couche 18 au moyen d'un faisceau laser ou d'une lampe de chauffage au-dessus des zones 16 et en déplaçant ensuite le faisceau laser au-dessus des îlots 14 (tirage latéral). En pratique, un chauffage de base (non localisé) de la tranche à une température de 1000 à 1100°C est assuré par des lampes placées à l'arrière de la tranche.

A la fin de cette phase de recristallisation, on laisse refroidir le substrat. Ce refroidissement produit les contraintes que l'on sait entre les deux matériaux monocristallins 10 et 18 là où ils sont en contact (zone 16). Des dislocations de structure cristalline se produisent à ces endroits. Mais là où l'oxyde 12 des îlots 14 sépare le silicium du corindon, la viscosité de l'oxyde pendant une grande partie de la phase de refroidissement est suffisante pour permettre d'absorbe les dilatations différentielles et d'éviter les dislocations.

Après refroidissement complet, on procède à une étape de photogravure du silicium monocristallin (gravure chimique ou par plasma, après dépôt, exposition, et développement d'une résine photosensible). Le motif de gravure est essentiellement le même que le motif de gravure des îlots 14, d'oxyde de silicium. Toutefois, il est de préférence légèrement réduit par rapport à ce dernier pour que l'on soit sûr que des dislocations engendrées à proximité des zones 16 ne subsistent pas vers les bords des îlots de silicium 20 qui restent sur le substrat après gravure (figure 5). Il est particulièrement aise et courant de réaliser à l'aide d'un ordinateur un masque présentant un motif légèrement rétreint par rapport au motif d'un autre masque.

Les étapes ultérieures de fabrication sont les mêmes que celles de tout autre circuit intégré sur substrat isolant, elles dépendent des éléments de circuit à réaliser. La figure 6 représente un transistor à effet de champ à grille isolé sur chaque îlot 20, avec une source 22, un drain 24, une région de canal 26, une grille isolée 28 et des contacts de source et de drain 30 et 32.

Il est à noter que la phase de formation de la couche de silicium monocristallin 18 constituant les îlots 20 peut aussi consister en une croissance épitaxiale directe (donc monocristalline dès le départ) à partir des germes de corindon dénudé. Dans ce cas, la couche 18 se constitue progressivement, au cours d'une décomposition de silane ou de composés chlorés de silicium à haute température, d'abord au-dessus des germes 16 de corindon puis latéralement au-dessus de la fine couche d'oxyde 14.

**Revendications**

1. Procédé de fabrication de circuits intégrés sur substrat isolant, consistant à former sur un substrat isolant monocristallin une couche semi-conductrice monocristalline, d'un matériau de structure cristalline suffisamment proche de celle du substrat isolant, à l'aide des étapes suivantes:

a) on dépose sur le substrat isolant (10) une fine couche d'oxyde de silicium (12),

b) on grave cet oxyde selon un motif de petits flots individuels (14),

c) on forme à haute température une couche semi-conductrice monocristalline (18) a partir des germes monocristallins constitués par les zones (16) de substrat situées entre les flots (14),

d) on grave la couche semi-conductrice (18) selon un motif correspondant essentiellement au motif de gravure de l'oxyde de silicium.

2. Procédé de fabrication selon la revendication 1, caractérisé en ce que pour former la couche semi-conductrice monoristalline, on dépose d'abord une couche semi-conductrice polycristalline puis on effectue à haute température une recristallisation de la couche à partir des germes constitués par les zones de substrat situées entre les îlots et recouvertes de la couche polycristalline.

3. Procédé de fabrication selon la revendication 1, caractérisé en ce que pour former la couche semi-conductrice monocristalline, on effectue une épitaxie avec débordement latéral, par décomposition de composé de silicium à haute température.

4. Procédé de fabrication selon la revendication 1, caractérisé en ce que la couche semi-conductrice monocristalline est gravée selon un motif légèrement rétreint par rapport au motif de la gravure de l'oxyde.

## Patentansprüche

1. Herstellungsverfahren für integrierte Schaltungen auf einem isolierenden Träger, wobei dieses Verfahren darin besteht, auf einem isolierenden, monokristallinen Träger eine monokristalline Halbleiterschicht zu bilden, aus einem Material, dessen Kristall struktur derjenigen des isolierenden Trägers ausreichend ähnlich ist, mittels folgender Schritte:

a) eine dünne Schicht aus Siliziumoxid (12) wird auf den isolierenden Träger (10) aufgebracht;

b) In dieses Oxid wird ein Motiv mit kleinen, einzelnen Inseln (14) eingraviert;

c) Bei hoher Temperatur wird eine monokristalline Halbleiterschicht (18) aus den monokristallinen Keimen gebildet, die von den sich zwischen den Inseln (14) befindenden Zonen (16) des Trägers gebildet werden;

d) die Halbleiterschicht (18) wird nach einem Motiv eingraviert, das im wesentlichen dem Eingraviermotiv des Siliziumoxids entspricht.

2. Herstellungsverfahren nach Anspruch 1, dadurch gekennzeichnet daß, um die monokristalline Halbleiterschicht zu bilden, eine polykristalline Halbleiterschicht zuerst aufgebracht wird, dann wird bei hoher Temperatur eine Rekristallisierung der Schicht aus den Keimen vorgenommen, die von den sich zwischen den Inseln befindenden und mit der polykristallinen Schicht überzogenen Zonen des Trägers gebildet sind.

3. Herstellungsverfahren nach Anspruch 1, dadurch gekennzeichnet daß, um die monokristalline Halbleiterschicht zu bilden, ein epitaktisches Wachsen mit seitlichem Übergriff vorgenommen wird, durch Zersetzung der Siliziumverbindung bei hoher Temperatur.

4. Herstellungsverfahren nach Anspruch 1, dadurch gekennzeichnet, daß die monokristalline Halbleiterschicht nach einem geringfügig verengten Motiv in Bezug auf das Motiv der Oxidgravur eingraviert wird.

## Claims

1. A process for the manufacture of integrated circuits on an insulating substrate, consisting of forming a monocrystalline semiconductor layer on an insulating monocrystalline substrate, said layer being of a material with a crystalline structure sufficiently similar to that of the insulating substrate, with the aid of the following steps:

(a) forming a fine layer of silicon oxide (12) on the insulating substrate (10),

(b) engraving this oxide in accordance with a design of individual islands (14),

(c) forming a monocrystalline semiconductor layer (18) at a high temperature from monocrystalline nuclei constituted by the zones (16) of the substrate formed under the islands (14), and

(d) engraving the semiconductor layer (18) with a design essentially the same as the engraved design of the silicon oxide.

2 The process of manufacture as claimed in claim 1 characterized in that for forming the monocrystalline semiconductor layer first a polycrystalline semiconductor layer is deposited, then it is caused to recrystallize at a high temperature starting from nuclei constituted by zones of the substrate situated between the islands and covered with the polycrystalline layer.

3. The process of manufacture as claimed in claim 1 characterized in that in order to form the monocrystalline semiconductor layer epitxial growth is caused with lateral overflow and by dint of decomposition of the silicon compound at a high temperature.

4. The process of manufacture as claimed in claim 1 characterized in that the monocrystalline layer is engraved in accordance with a design which is slightly reduced in comparison with the design of the engraved oxide.

0 179 719

FIG_1

FIG_2

FIG_3

FIG_4

FIG_5

FIG_6

1